# EUROPEAN PATENT APPLICATION

(11) **EP 2 783 758 A1**
(43) Date of publication of application: **01.10.2014**
(21) Application number: 14150953.9
(22) Date of filing: 13.01.2014
(51) Int. Cl.: B06B 1/06

(54) **Ultrasonic Probe and Manufacturing Method Thereof**

(30) Priority: 28.03.2013 KR 20130033419
(71) Applicant: Samsung Medison Co., Ltd., Gangwon-do 250-870 (KR)
(72) Inventor: Kim, Soo Jin, Gyeongsangbuk-do (KR)
(74) Representative: Schmid, Wolfgang

(57) **Abstract**

An ultrasonic probe including an acoustic module including a transducer layer to generate an ultrasonic wave, a matching layer to reduce an acoustic impedance difference between the transducer layer and a subject, and a backing layer to absorb a ultrasonic wave generated from the transducer layer and proceeding toward a rear, and a plurality of lens layers configured to focus a ultrasonic wave proceeding toward a front of the transducer layer, and each including a different physical property, so that the reception of the ultrasonic wave signal is improved while maintaining wear resistance characteristic and chemical resistance characteristic, as well as the stability with respect to withstanding voltage.

## Description

### CROSS-REFERENCE TO RELATED APPLICATION

This application claims the benefit of the Korean Patent Application No. 2013-0033419, filed on March 28, 2013, in the Korean Intellectual Property Office, the disclosure of which is incorporated herein by reference.

### BACKGROUND

### 1. Field

Embodiments of the present disclosure relate to an ultrasonic probe configured to generate an image of an inside a subject by using an ultrasonic wave.

### 2. Description of the Related Art

An ultrasonic diagnostic apparatus is an apparatus configured to radiate an ultrasonic wave signal toward a desired portion of an inside the body of a subject from the surface of the body of the subject, and to obtain an image with respect to a cross section or a blood stream of the soft tissue of the subject by using the information of the reflected ultrasonic wave, that is, the ultrasonic echo signal, through a non-invasive measurement. The ultrasonic diagnostic apparatus, when compared to other image diagnostic apparatuses such as an X-ray diagnostic apparatus, an X-ray Computerized Tomography Scanner (CT Scanner), a MRI(a magnetic resonance image), and a nuclear medicine diagnostic apparatus, is small, less expensive, capable of displaying images in real time, and provided with higher level of safety due to no exposure to radiation such as an X-ray, and thus is widely used in diagnosis of heart, abdomen, urinary system, and obstetrics and gynecology.

The ultrasonic diagnostic apparatus, in order to obtain an ultrasonic image of the subject, includes an ultrasonic probe configured to transmit an ultrasonic wave signal to a subject, and to receive the reflected ultrasonic wave signal from the subject.

The ultrasonic probe includes a transducer layer configured to reciprocally convert an electrical signal and an acoustic signal as piezo-electric material is vibrated, a matching layer configured to reduce the acoustic impedance difference between the piezo-electric layer and the subject as for the ultrasonic wave generated from the transducer layer is delivered at the fullest, a lens layer configured to focus the ultrasonic wave proceeding toward the front of the piezo-electric layer to a particular point, and a backing layer configured to prevent a distortion of an image by blocking the ultrasonic wave from proceeding to the rear of the piezo-electric layer.

### SUMMARY

Therefore, it is an aspect of the present disclosure to provide an ultrasonic probe having stability with respect to a withstanding voltage while provided with a plurality of lens layers, each having a different physical property, at the ultrasonic probe, and a manufacturing method thereof.

It is another aspect of the present disclosure to provide an ultrasonic probe configured to maintain wear resistance characteristic and chemical resistance characteristic while improving the reception of an ultrasonic wave by forming a plurality of lens layers each having a different physical property, including a first lens layer formed with attenuation resistance material, and a second lens layer formed with material having strong wear resistance characteristic, and by forming a protective layer having a chemical shield in between an acoustic module and the first lens layer, or in between the first lens layer and the second lens layer, and a manufacturing method thereof.

Additional aspects of the disclosure will be set forth in part in the description which follows and, in part, will be obvious from the description, or may be learned by practice of the disclosure.

In accordance with an aspect of the present disclosure, an ultrasonic probe includes an acoustic module, and a plurality of lens laser. The acoustic module may include a transducer layer to generate an ultrasonic wave, a matching layer to reduce an acoustic impedance difference between the transducer layer and a subject, and a backing layer to absorb an ultrasonic wave generated from the transducer layer and proceeding toward a rear. The plurality of lens layers may be configured to focus a ultrasonic wave proceeding toward a front of the transducer layer, and each includes a different physical property.

The plurality of lens layers may include a first lens layer formed of epoxy material to prevent the ultrasonic wave generated from the transducer layer from being attenuated, and a second lens layer formed of aluminum material having strong wear resistance characteristic to focus the ultrasonic wave and to protect the acoustic module.

The first lens layer may be formed in a way to cover a portion of a cutting section (kerf) of the acoustic module.

The ultrasonic probe may further include a protective layer formed in between the matching layer and the first lens layer.

The protective layer may include a chemical shield or a Radio Frequency (RF) shield.

The chemical shield may be formed by performing a parylene coating on an upper surface of the matching layer and on a portion of a side surface of the acoustic module.

The chemical shield may be formed by applying a section sputter, which includes a nichrome (NiCr) layer and a titanium (Ti) layer, to a polymer film.

The ultrasonic probe may further include a protective layer formed in between the first lens layer and the second lens layer.

The protective layer may include a chemical shield or a Radio Frequency (RF) shield.

The chemical shield may be formed by performing a parylene coating on an upper surface and a side surface of the first lens layer.

The chemical shield may be formed by applying a section sputter, which includes a nichrome (NiCr) layer and a titanium (Ti) layer, to a polymer film.

In accordance with another aspect of the present disclosure, a method of manufacturing an ultrasonic probe includes generating an acoustic module by sequentially stacking a backing layer, a transducer layer, and a matching layer, and forming a plurality of lens layers configured to focus a ultrasonic wave proceeding toward a front of the transducer layer to a particular position, and each formed of material having a different physical property.

The plurality of lens layers may include a first lens layer formed of epoxy material to prevent the ultrasonic wave generated from the transducer layer from being attenuated, and a second lens layer formed of aluminum material having strong wear resistance characteristic to focus the ultrasonic wave while protecting the acoustic module.

The first lens layer may be formed in a way to cover a portion of a cutting section (kerf) of the acoustic module.

The method may further include forming a protective layer in between the matching layer and the first lens layer.

The protective layer may include a chemical shield or a RF shield.

The chemical shield may be formed by performing a parylene coating on an upper surface of the matching layer and on a portion of a side surface of the acoustic module.

The chemical shield may be formed by applying a section sputter, which includes a nichrome (NiCr) layer and a titanium (Ti) layer, to a polymer film.

The method may further include forming a protective layer in between the first lens layer and the second lens layer.

The protective layer may include a chemical shield or a RF shield.

The chemical shield may be formed by performing a parylene coating on an upper surface and a side surface of the first lens layer.

The chemical shield may be formed by applying a section sputter, which includes a nichrome (NiCr) layer and a titanium (Ti) layer, to a polymer film.

### BRIEF DESCRIPTION OF THE DRAWINGS

These and/or other aspects of the disclosure will become apparent and more readily appreciated from the following description of the embodiments, taken in conjunction with the accompanying drawings of which:
FIG. 1 is an exterior perspective view of an ultrasonic diagnostic apparatus having applied thereto with an ultrasonic probe in accordance with one embodiment of the present disclosure.
FIG. 2 is a cross-sectional view showing a structure of the ultrasonic probe in accordance with one embodiment of the present disclosure.
FIG. 3 is a drawing illustrating an example of a structure of a protective layer (a chemical shield) of the ultrasonic probe in accordance with one embodiment of the present disclosure.
FIG. 4 is a flow chart illustrating a manufacturing method of an ultrasonic probe in accordance with one embodiment of the present disclosure.
FIG. 5 is a cross-sectional view showing a structure of a ultrasonic probe in accordance with another embodiment of the present disclosure.
FIG. 6 is a flow chart illustrating a manufacturing method of a ultrasonic probe in accordance with another embodiment of the present disclosure.

### DETAILED DESCRIPTION

Reference will now be made in detail to the embodiments of the present disclosure, examples of which are illustrated in the accompanying drawings, wherein like reference numerals refer to like elements throughout.

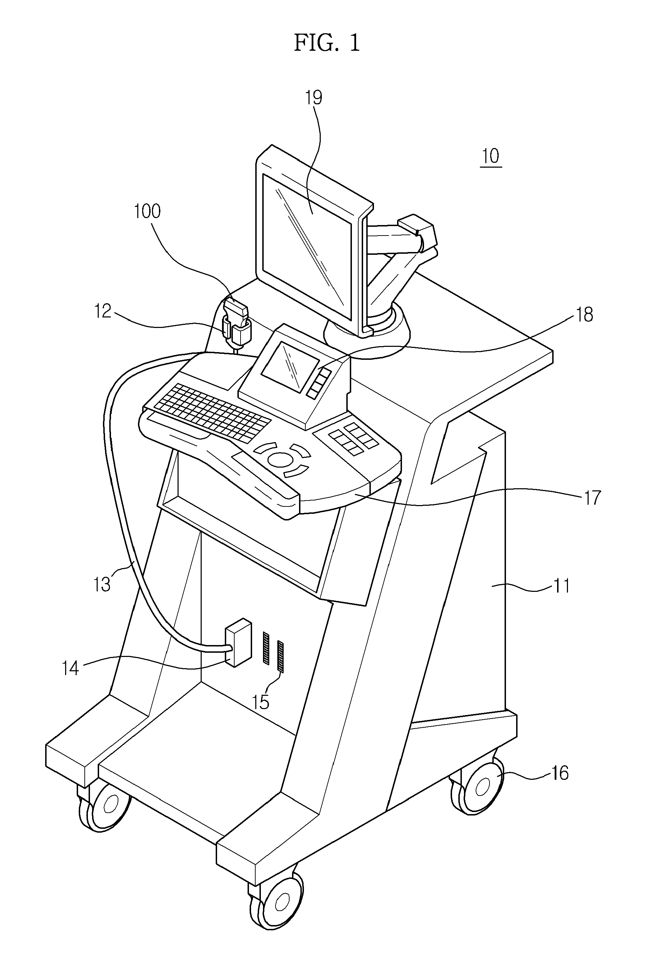

FIG. 1 is an exterior perspective view of an ultrasonic diagnostic apparatus having applied thereto with an ultrasonic probe in accordance with one embodiment of the present disclosure.

As illustrated on FIG. 1, an ultrasonic diagnostic apparatus 10 may include a body 10, an ultrasonic probe 100, an input unit 17, a sub display unit 18, and a main display unit 19.

The body 11 may accommodate main components of the ultrasonic diagnostic apparatus 10, for example, a transmission signal generating unit (not shown). In a case when a patient inputs an ultrasonic diagnosis command, the transmission signal generating unit (not shown) may generate a transmission signal and transmit the transmission signal to the ultrasonic probe 100.

At one side of the body 11, at least one female connector 15 may be provided. A male connector 14 connected to a cable 13 may be physically coupled to the female connector 15. The transmission signal generated by the transmission signal generating unit (not shown) may be transmitted to the ultrasonic probe 100 through the male connector 14, connected to the female connector 15 of the body 11, and the cable 13.

Meanwhile, at a lower portion of the body 11, a plurality of casters 16 configured for a movablity of the ultrasonic diagnostic apparatus 10 may be provided. The plurality of casters 16 may be capable of fixing at a particular place, or moving the ultrasonic diagnostic apparatus 10 toward a particular direction.

The ultrasonic probe 100 is a portion to make contact with the surface of the body of a subject, for example, an abdomen of a pregnant female, and may be able to transmit/receive an ultrasonic wave. Particularly, the ultrasonic probe 100 radiates a transmission signal, that is, an ultrasonic wave signal, provided from the body 11 to an inside the human body of a subject, receives the reflected ultrasonic echo signal from a particular portion, for example, a fetus, of an inside the human body of the subject, and transmits the reflected ultrasonic echo signal to the body 11.

For the above, at one end portion of one side of the ultrasonic probe 100, a plurality of ultrasonic transducers configured to generate an ultrasonic wave according to an electrical signal may be provided.

The ultrasonic transducer is configured to generate an ultrasonic wave according to an applied alternating current power. In detail, the ultrasonic transducer may be able to receive an alternating current power from an outside power supply source or from an inside capacitating apparatus, for example, a battery. A piezo-electric oscillator or a thin film of the ultrasonic transducer is configured to vibrate according to the provided alternating current power, as to generate an ultrasonic wave.

With respect to the ultrasonic transducer, various ultrasonic transducers, for example, a magnetostrictive ultrasonic transducer using a magnetostrictive effect of a magnetic substance, a piezo-electric ultrasonic transducer using a piezo-electric effect of a piezo-electric substance, a capacitive micromachined ultrasonic transducer (cMUT) configured to transmit/receive an ultrasonic wave by using a vibration of hundreds and thousands of micro-processed thin films, may be used.

The plurality of ultrasonic transducers may be arranged in the form of a linear array, or in the form of a convex array. At an upper portion of the ultrasonic transducer, a cover to cover the ultrasonic transducer may be provided.

The cable 13 is connected to the end portion of the other side of the ultrasonic probe 100, and the male connector 14 may be connected to the end portion of the cable 13. The male connector 14 may be physically coupled to the female connector 15 of the body 11.

The input unit 17 is a portion that may receive input command related to an operation of the ultrasonic diagnostic apparatus 10. For example, a mode selection command including an A-mode (Amplitude mode), a B-mode (Brightness mode), or a M-mode (Motion mode), or an ultrasonic diagnosis start command may be input through the input unit 17. The command input through the input unit 17 may be transmitted to the body 11 by a wired communication or a wireless communication.

The input unit 17 may include at least one of a touchpad, a keyboard, a foot switch, and a foot pedal, for example. The touchpad or the keyboard is implemented in the form of hardware, and may be positioned at an upper side of the body 11. The keyboard may include at least one of a switch, a key, a wheel, a joystick, a trackball, and a knop. As another example, the keyboard may be implemented in the form of software such as a graphic user interface. In the case as such, the keyboard may be displayed through the sub display unit 18 and the display unit 19. The foot switch or the foot pedal may be provided at a lower side of the body 11, and an operator may be able to control the operation of the ultrasonic diagnostic apparatus 10 by using the foot pedal.

At the surroundings of the input unit 17, a probe holder 12 configured to hold the ultrasonic probe 100 may be provided. A patient, when not using the ultrasonic diagnosis apparatus 10, may store the ultrasonic probe 100 by holding the ultrasonic probe 100 at the probe holder 12. FIG. 1 illustrates the case of the one probe holder 12 provided at the surroundings of the input unit 17, but the present disclosure is not limited hereto, and the position or the number of the probe holder 12 may be variably changed, according the overall design of the ultrasonic diagnostic apparatus 10, or the design or the position of some of the components of the ultrasonic diagnostic apparatus 10.

The sub display unit 18 may be provided at the body 11. FIG. 1 shows the case of the sub display unit 18 provided at an upper side of the input unit 17. The sub display unit 18, for example, may be implemented with a cathode ray tube (CRT) or a liquid crystal display (LCD). The sub display unit 18 as such may be able to display a menu or information needed for an ultrasonic diagnosis.

The main display unit 19 may be provided at the body 11. FIG. 1 shows the case of the main display unit 19 provided at an upper side of the sub display unit 18. The main display unit 19, for example, may be implemented with a cathode ray tube (CRT) or a liquid crystal display (LCD). The main display unit 19 may be able to display an ultrasonic image obtained from an ultrasonic diagnostic process. The ultrasonic image displayed through the main display unit 19 may include at least one of a two-dimensional black/white ultrasonic image, a two-dimensional color ultrasonic image, a three-dimensional black/white ultrasonic image, and a three-dimensional color ultrasonic image.

Although both of the sub display unit 18 and the main display unit 19 are illustrated as being provided on the ultrasonic diagnostic apparatus 10 in FIG. 1, in another case, the sub display unit 18 may be omitted. In this case, the application and menu needing to be displayed through the sub display unit 18 may be displayed through the main display unit 19.

In addition, at least one of the sub display unit 18 and the main display unit 19 may be implemented to be separated from the body 11.

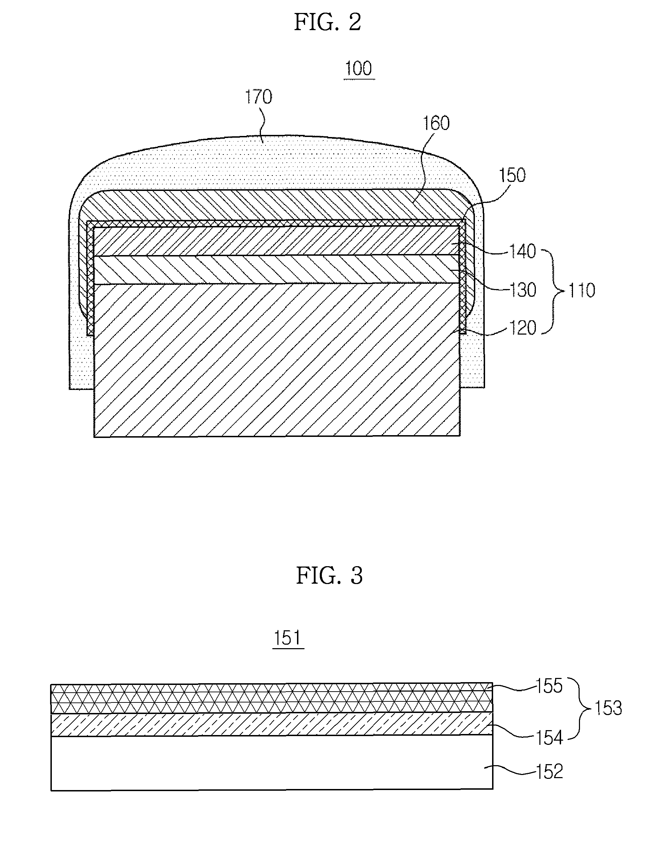

FIG. 2 is a cross-sectional view showing a structure of the ultrasonic probe in accordance with one embodiment of the present disclosure, and FIG. 3 is a drawing illustrating an example of a structure of a protective layer, that is, a chemical shield, of the ultrasonic probe in accordance with one embodiment of the present disclosure.

As illustrated on FIG. 2, the ultrasonic probe 100 in accordance with one embodiment of the present disclosure includes an acoustic module 110 including a transducer layer 130, a backing layer 120 provided at a lower surface of the transducer layer 130, and a matching layer 140 provided at an upper surface of the transducer layer 130, a protective layer 150 covering an upper surface and a portion of a side surface of the acoustic module 110, a first lens layer 160 covering an upper surface and a side surface of the protective layer 150, and a second lens layer 170 covering an upper surface and a side surface of the first lens layer 160.

With respect to the ultrasonic transducer, various ultrasonic transducers, for example, a magnetostrictive ultrasonic transducer using a magnetostrictive effect of a magnetic substance, a piezo-electric ultrasonic transducer using a piezo-electric effect of a piezo-electric substance, a capacitive micromachined ultrasonic transducer (cMUT) configured to transmit/receive an ultrasonic wave by using a vibration of hundreds and thousands of micro-processed thin films, may be used. Hereinafter, the piezo-electric ultrasonic transducer may be used as one embodiment of the transducer for a description.

An effect, in which predetermined predetermined voltage is produced when a mechanical pressure is applied to a predetermined material, and a mechanical change occurs when a voltage is applied, is referred to as the piezo-electric effect or the reverse piezo-electric effect, and the material having the effect as such is referred to as the piezo-electric material.

That is, the piezo-electric material is referred to as the material changing electrical energy into mechanical vibration energy, and mechanical vibration energy into electrical energy.

The ultrasonic probe 100 in accordance with one embodiment of the present disclosure includes the transducer layer 130 composed of the piezo-electric material that generates an ultrasonic wave by changing electrical energy into mechanical vibration at the time of when electrical signal is applied.

The piezo-electric material that forms the transducer layer 130 may include lead zirconate titanate ceramic (PZT), a PMZT mono-crystal composed of a solid solution of lead magnesium niobate and lead titanate, or a PZNT mono-crystal composed of a solid solution of lead zinc niobate and lead titanate.

In addition, the transducer layer 130 may be arranged in the structure of a single layer or multiple layers.

In general, the transducer layer 130 of the multiple-layer structure is convenient in adjusting impedance and voltage, and may be able to obtain superior reception, efficiency in energy conversion, and soft spectrum.

The backing layer 120 is installed at a lower surface of the transducer layer 130, and by absorbing the ultrasonic wave generated from the transducer layer 130 and proceeding toward a rear, blocks the proceeding of the ultrasonic wave toward the rear of the transducer layer 130, and thus, a distortion of an image may be prevented form occurring. The backing layer 120 may be manufactured in the form of a plurality of layers to improve the attenuating effect or blocking effect of an ultrasonic wave.

The matching layer 140 is installed at an upper surface of the transducer layer 130. The matching layer 140 enables the ultrasonic wave generated from the transducer layer 130 to be efficiently delivered to a subject by matching the acoustic impedance of the transducer layer 130 and the subject by reducing the acoustic impedance difference between the transducer layer 130 and the subject.

For the above, the matching layer 140 may be provided in a way to have an acoustic impedance value that is between the acoustic impedance of the transducer layer 130 and the acoustic impedance of the subject.

The matching layer 140 may be formed with glass or resin material.

In addition, as for the acoustic impedance be changed toward a subject from the transducer layer 130 in a stepwise manner, the matching layer 140 may be formed in the plurality of matching layers, and plurality of matching layers 140 each may be composed of different material.

The transducer layer 130 and the matching layer 140 may be processed in the form of a two-dimensional array having the shape of a matrix through a dicing process, or may be processed in the shape of a one-dimensional array.

The protective layer 150 may be installed to cover an upper surface of the matching layer 140 and a portion of a side surface of the acoustic module 110. The protective layer 150may include a chemical shield, which is formed by coating or depositing conductive material on the surface of a film having moisture resistance characteristic and chemical resistance characteristic, and serves to protect internal components from water and the chemicals being used for sterilization. The chemical shield may be formed by performing parylene coating on an upper surface of the matching layer 140 and a portion of a side surface of the acoustic module 110. In addition, the chemical shield may be formed by applying a section sputter on a polymer film. That is, as illustrated on FIG. 3, the chemical shield 151 may include a polymer film 152 and a section sputter 153.

The polymer film 152 is composed of polyetherimide (PEI). At this time, the polymer film 152 may be provided with the thickness thereof in the range of 5 *µ*m and 10 *µ*m (more particularly, approximately 7 *µ*m), and may be attached to the first lens layer 160.

The section sputter 153 is deposited on an upper end of the polymer film 152, and is composed of a nichrome (NiCr) layer 154 and a titanium (Ti) layer 155. At this time, the thickness of the NiCr layer may be in the range of 50 Å and 200 Å (more particularly, approximately 100 Å) and the thickness of the Ti layer 155 may be in the range of 500 Å and 2000 Å (more particularly, 1000 Å), and at an upper end of the NiCr layer 154, the Ti layer 155 may be formed.

In addition, the protective layer 150 may include a Radio Frequency Shield (RF Shield) configured to prevent the discharging of high frequency component that may occur at the transducer layer 130 to an outside, and also configured to block the introduction of the high frequency signal of an outside.

The first lens layer 160 may be installed to cover an upper surface and a side surface of the protective layer 150. The first lens layer 160 may be formed of low attenuation material, for example, epoxy material, to prevent the attenuation of the ultrasonic wave signal generated from the transducer layer 130, and more particularly, low viscosity epoxy resin (DER322) or DEH24 may be used. As the above, by using the low attenuation material, the first lens layer 160 may be manufactured, and thus the reception of the ultrasonic wave signal may be improved.

In addition, the first lens layer 160 is installed to cover a portion of a cutting section (kerf) of the acoustic module 110, that is, a portion of the side surface of the acoustic module 110, and thus a crosstalk may be reduced.

The second lens layer 170 may be installed to cover an upper surface and a side surface of the first lens layer 160. The second lens layer 170 focuses the ultrasonic wave proceeding toward a front of the transducer 130 to a particular point. The second lens layer 170 may be composed of the material having strong wear resistance characteristic and capable of delivering ultrasonic wave at high speed, to focus ultrasonic wave and to perform a role in protecting the acoustic module 110, particularly, the transducer layer 130. The second lens layer 170 may be provided with the shape of a convex form in a radial direction of an ultrasonic wave so as to focus the ultrasonic wave, or in the case when the speed of sound is slower than in a human body, may be provided with the shape of a concave form.

In the present disclosure, the plurality of lens layers having different physical property, that is, the first lens layer 160 composed of the low attenuation material, and the second lens layer 170 composed of the material with strong wear resistance characteristic are provided at the ultrasonic probe 100, and the protective layer 150 having the chemical shield 151 is formed in between the acoustic module 110 and the first lens layer 160, thereby able to maintain the wear resistance characteristic and chemical resistance characteristic while improving the reception of the ultrasonic wave signal, and at the same time, the lens layer may be formed in a great thickness (the multi layers of the lens layers" and thus the stability with respect to withstanding voltage may be obtained.

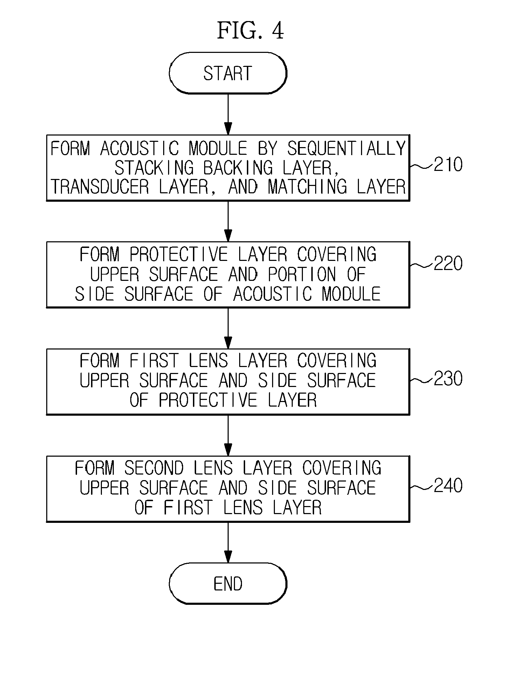

FIG. 4 is a flow chart illustrating a manufacturing method of a ultrasonic probe in accordance with one embodiment of the present disclosure.

First, the acoustic module is formed by sequentially stacking the backing layer 120, the transducer layer 130, and the matching layer 140 (210).

Next, the protective layer 150 covering an upper surface and a portion of a side surface of the acoustic module 110 is formed (220). The protective layer 150 may include a chemical shield that is formed by coating or depositing conductive material on the surface of the film having moisture resistance characteristic and chemical resistance characteristic and serves to protect internal components from water and the chemicals being used for sterilization. The chemical shield may be formed by performing parylene coating on an upper surface of the matching layer 140 or on a portion of a side surface of the acoustic module 110, or by applying a section sputter to a polymer film. In addition, the protective layer 150 may include a Radio Frequency Shield (RF Shield) configured to prevent the discharging of high frequency component that may occur at the transducer layer 130 to an outside, and also configured to block the introduction of the high frequency signal of an outside.

Then, the first lens layer 160 covering an upper surface and a side surface of the protective layer 150 is formed (230). The first lens layer 160 may be formed with low attenuation material, for example, epoxy material, to prevent the ultrasonic wave signal generated at the transducer layer 130 from being attenuated. In addition, the first lens layer 160 is installed to cover a portion of the cutting section (kerf) of the acoustic module 110, that is, a portion of the side surface of the acoustic module 110, and thus a crosstalk may be reduced.

Next, the second lens layer 170 covering an upper surface and a side surface of the first lens layer 160 is formed (240). The second lens layer 170 may be formed of material having strong wear resistance to focus an ultrasonic wave and protect the acoustic module 110, in particular, the transducer layer 130, and capable of The second lens layer 170 may be provided with the shape of a convex form in a radial direction of an ultrasonic wave to focus the ultrasonic wave, or in the case when the speed of sound is slower than in a human body, may be provided with the shape of a concave form.

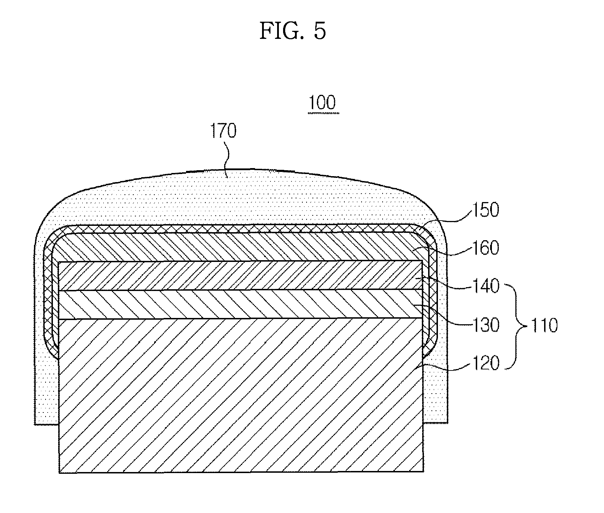

FIG. 5 is a cross-sectional view showing a structure of a ultrasonic probe in accordance with another embodiment of the present disclosure.

Referring to FIG. 2 and FIG. 4, the structure and the manufacturing method of the ultrasonic probe 100 in accordance with one embodiment of the present disclosure are described hereinabove. FIG. 2 illustrates the case when the protective layer 150 having the chemical shield 151 and/or the RF shield is formed in between the acoustic module 110 and the first lens layer 160, but as illustrated on FIG. 5, the protective layer 150 having the chemical shield 151 and/or the RF shield may be formed in a way to be disposed in between the first lens layer 160 and the second lend layer 170.

The structure of the ultrasonic probe illustrated on FIG. 5, when compared to the structure of the ultrasonic probe illustrated on FIG. 2, is different only in the aspect that the protective layer 150 is provided to be disposed in between the first lens layer 160 and the second lend layer 170, and remaining components other than the above are same as the components of the ultrasonic probe illustrated on FIG. 2, and thus the detailed descriptions will be omitted.

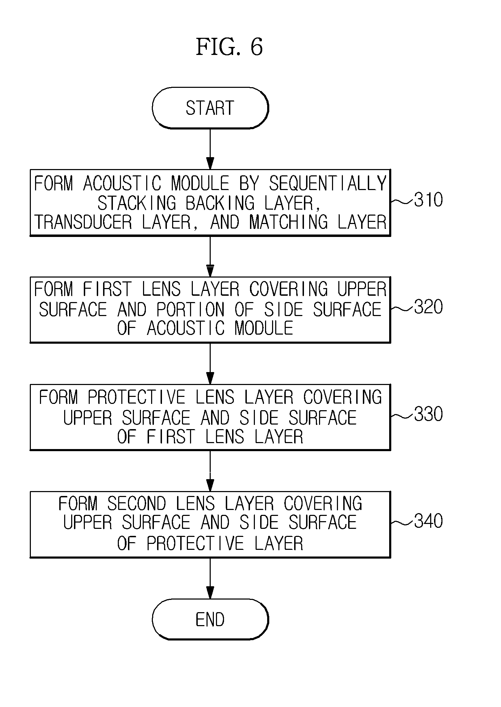

FIG. 6 is a flow chart illustrating a manufacturing method of a ultrasonic probe in accordance with another embodiment of the present disclosure.

First, the acoustic module is formed by sequentially stacking the backing layer 120, the transducer layer 130, and the matching layer 140 (310).

Next, the first lens layer 160 covering an upper surface and a portion of a side surface of the acoustic module 110 is formed (320). The first lens layer 160 may be formed with low attenuation material, for example, epoxy material, to prevent the ultrasonic wave signal generated at the transducer layer 130 from being attenuating. In addition, the first lens layer 160 is installed to cover a portion of the cutting section (kerf) of the acoustic module 110, that is, a portion of the side surface of the acoustic module 110, and thus a crosstalk may be reduced.

Then, the protective layer 150 covering an upper surface and a side surface of the first lens layer 160 is formed (330). The protective layer 150may include a chemical shield which is formed by coating or depositing conductive material on the surface of the film having moisture resistance characteristic and chemical resistance characteristic and serves to protect internal components from water and the chemicals being used for sterilization. The chemical shield may be formed by performing parylene coating on an upper surface of the first or on a portion of a side surface of the first lens layer, or by applying a section sputter to a polymer film. In addition, the protective layer 150 may include a Radio Frequency Shield (RF Shield) configured to prevent the discharging of high frequency substance that may occur at the transducer layer 130 to an outside, and also configured to block the introduction of the high frequency signal of an outside.

Next, the second lens layer 170 covering an upper surface and a side surface of the protective layer 150 is formed (340). The second lens layer 170 may be formed with material having strong wear resistance characteristic and capable of delivering ultrasonic wave at high speed to focus the ultrasonic wave, and to protect the acoustic module 110, particularly the transducer layer 130. The second lens layer 170 may be provided with the shape of a convex form in a radial direction of ultrasonic wave to focus the ultrasonic wave, or in the case when the speed of sound is slower than in a human body, may be provided with the shape of a concave form.

In the embodiment of the present disclosure, the case of when the two units of lens layers 160 and 170 formed at the ultrasonic probe 110 is described as an example, but forming more than three units of lens layers at the ultrasonic probe 110 may be possible, while the more than three units of lens layers are provided in a way to have different physical properties to each other

Although a few embodiments of the present disclosure have been shown and described, it would be appreciated by those skilled in the art that changes may be made in these embodiments without departing from the principles and spirit of the disclosure, the scope of which is defined in the claims and their equivalents.

## Claims

1. An ultrasonic probe, comprising:
an acoustic module including a transducer layer to generate an ultrasonic wave, a matching layer to reduce an acoustic impedance difference between the transducer layer and a subject, and a backing layer to absorb a ultrasonic wave generated from the transducer layer and proceeding toward a rear; and
a plurality of lens layers configured to focus a ultrasonic wave proceeding toward a front of the transducer layer to a predetermined position, and each including a different physical property.

2. The ultrasonic probe of claim 1, wherein the plurality of lens layers comprise:
a first lens layer formed of epoxy material to prevent the ultrasonic wave generated from the transducer layer from being attenuated; and
a second lens layer formed of aluminum material having strong wear resistance characteristic to focus the ultrasonic wave while protecting the acoustic module.

3. The ultrasonic probe of claim 2, further comprising a protective layer formed in between the matching layer and the first lens layer,
wherein the protective layer includes a chemical shield or a Radio Frequency (RF) shield.

4. The ultrasonic probe of claim 3, wherein the chemical shield is formed by performing a parylene coating on an upper surface of the matching layer and on a portion of a side surface of the acoustic module.

5. The ultrasonic probe of claim 2, further comprising a protective layer formed in between the first lens layer and the second lens layer,
wherein the protective layer includes a chemical shield or a Radio Frequency (RF) shield.

6. The ultrasonic probe of claim 5, wherein the chemical shield is formed by performing a parylene coating on an upper surface and a side surface of the first lens layer.

7. The ultrasonic probe of claim 3 or 5, wherein the chemical shield is formed by applying a section sputter, which includes a nichrome (NiCr) layer and a titanium (Ti) layer, to a polymer film.

8. A method of manufacturing an ultrasonic probe, the method comprising:
generating an acoustic module by sequentially stacking a backing layer, a transducer layer, and a matching layer; and
forming a plurality of lens layers configured to focus a ultrasonic wave proceeding toward a front of the transducer layer to a predetermined position, and each formed of material having a different physical property.

9. The method of claim 8, wherein the plurality of lens layers include a first lens layer formed of epoxy material to prevent the ultrasonic wave generated from the transducer layer from being attenuated; and
a second lens layer formed of aluminum material having strong wear resistance characteristic to focus the ultrasonic wave while protecting the acoustic module.

10. The method of claim 9, further comprising forming a protective layer in between the matching layer and the first lens layer,
wherein the protective layer includes a chemical shield or a Radio Frequency (RF) shield.

11. The method of claim 10, wherein the chemical shield is formed by performing a parylene coating on an upper surface of the matching layer and on a portion of a side surface of the acoustic module.

12. The method of claim 9, further comprising a protective layer formed in between the first lens layer and the second lens layer,
wherein the protective layer includes a chemical shield or a Radio Frequency (RF) shield.

13. The method of claim 12, wherein the chemical shield is formed by performing a parylene coating on an upper surface and a side surface of the first lens layer.

14. The method of claim 10 or 12, wherein the chemical shield is formed by applying a section sputter, which includes a nichrome (NiCr) layer and a titanium (Ti) layer, to a polymer film.
